Europäisches Patentamt

European Patent Office

Office européen des brevets

(19)

(11) Veröffentlichungsnummer: **0 025 104**
**B1**

(12) # EUROPÄISCHE PATENTSCHRIFT

(45) Veröffentlichungstag der Patentschrift:
09.02.83

(21) Anmeldenummer: **80104409.0**

(22) Anmeldetag: **26.07.80**

(51) Int. Cl.³: **H 03 K  17/22,** H 03 K  17/30

(54) Schaltungsanordnung zur Ableitung eines Normiersignals bei Einschalten einer konstanten Betriebsspannung und zweier Taktspannungen.

(30) Priorität: **06.09.79  DE 2936000**

(43) Veröffentlichungstag der Anmeldung:
**18.03.81 Patentblatt 81/11**

(45) Bekanntmachung des Hinweises auf die Patenterteilung:
**09.02.83 Patentblatt 83/6**

(84) Benannte Vertragsstaaten:
**DE FR GB IT NL**

(56) Entgegenhaltungen:
**FR-A-2 256 597**
**FR-A-2 310 660**
**GB-A-1 337 910**

(73) Patentinhaber: **Deutsche ITT Industries GmbH,
Hans-Bunte-Strasse 19 Postfach 840, D-7800 Freiburg
(DE)**

(84) Benannte Vertragsstaaten: **DE**

(73) Patentinhaber: **ITT INDUSTRIES INC., 320 Park Avenue,
New York, NY 10022 (US)**

(84) Benannte Vertragsstaaten: **FR GB IT NL**

(72) Erfinder: **Strohl, Klaus Dieter, Dipl.-Ing.,
Steinackerstrasse 3c, D-7803 Gundelfingen (DE)**

(74) Vertreter: **Stutzer, Gerhard, Dr., Deutsche ITT Industries
GmbH Patent- und Lizenzabteilung
Hans-Bunte-Strasse 19 Postfach 840, D-7800 Freiburg
(DE)**

## Schaltungsanordnung zur Ableitung eines Normiersignals bei Einschalten einer konstanten Betriebsspannung und zweier Taktspannungen

Die Erfindung betrifft eine Schaltungsanordnung zur Ableitung eines Normiersignals bei Einschalten einer konstanten Betriebsspannung entsprechend dem Oberbegriff des Patentanspruchs. Derartige Schaltungen werden von der Anmelderin schon länger in auf dem Markt befindlichen integrierten Schaltungen verwendet, insbesondere in den Ultraschall-Fernsteuerungs-ICs SAA 1024. Die Schaltungsanordnung nach dem Oberbegriff des Anspruchs ist jedoch seitens der Anmelderin bisher druckschriftlich nicht veröffentlicht worden.

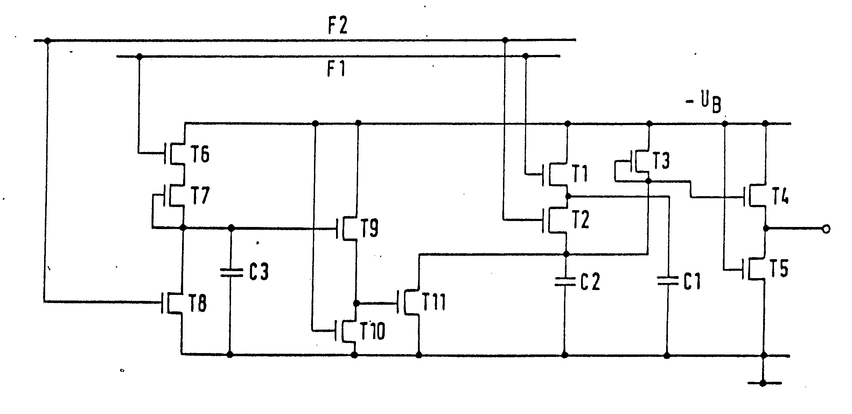

Zur Erläuterung des der Erfindung zugrundeliegenden Problems wird auf die Funktion der bekannten Schaltung zurückgegriffen, die anhand der Figur der Zeichnung im folgenden kurz erklärt werden soll. Nach Einschalten der Betriebsspannung $-U_B$ und der beiden Taktspannungen F1, F2 wird der erste Kondensator C1 während der Leitendsteuerung des ersten Ladetransistors T1 aufgeladen. In der anschließenden Sperrphase des ersten Ladetransistors T1 wird der Umladetransistor T2 von der zweiten Taktspannung F2 leitend gesteuert, so daß die zuvor im ersten Kondensator gespeicherte Ladung auf den zweiten Kondensator C2, dessen Kapazität wesentlich größer ist als die des ersten Kondensators C1, vollständig umgeladen wird. Dieser Vorgang wiederholt sich während mehrerer Perioden der Taktspannungen F1, F2 und führt schließlich dazu, daß die Schwellwertspannung des aus den Transistoren T4, T5 gebildeten Sourcefolgers überschritten wird, zu welchem Zeitpunkt das entsprechende Normiersignal an dessen Ausgang entsteht. Der zwischen dem Eingang des Sourcefolgers, also dem Gate des Transistors T4, und der Betriebsspannung $-U_B$ liegende erste Entladetransistor T3 mit direkter Source-Gate-Verbindung sorgt für eine Entladung des zweiten Kondensators C2 bei Abschalten der Betriebsspannung $-U_B$ oder bei kurzzeitigen Unterbrechungen oder Spannungseinbrüchen. Im eingeschwungenen Zustand ist der zweite Kondensator C2 also immer aufgeladen, so daß am Ausgang des ersten Sourcefolgers ein entsprechendes konstantes Potential liegt.

Der Betrieb der durch dieses Signal als Normiersignal angesteuerten Schaltung kann es nun jedoch erforderlich machen, die Taktspannungen vorübergehend abzuschalten. Dies kann beispielsweise dann auftreten, wenn mittels der Taktspannungen betriebene Zähler durch deren Abschalten sozusagen angehalten werden sollen. In derartigen Betriebszuständen ist die Ladung des zweiten Kondensators C2 lediglich von dessen Isolationsverhältnissen abhängig, d. h., die Ladung kann durch Leckströme mehr oder weniger geringfügig abnehmen. An sich ist es jedoch erwünscht, daß die Schaltung bei Wiedereinschalten der Taktspannungen das Normiersignal wieder erzeugt. Bei guten Isolationsverhältnissen des zweiten Kondensators C2 und insbesondere nach nur kurzzeitigem Abschalten der Taktspannungen wird dies also nicht der Fall sein, da praktisch noch die vorausgegangene Ladung vorhanden ist.

Die Aufgabe der Erfindung besteht darin, die bekannte Schaltungsanordnung zur Ableitung eines Normiersignals entsprechend dem Oberbegriff des Patentanspruchs so weiterzubilden, daß nach jedem Abschalten bei Wiedereinschalten der Taktspannungen das Normiersignal erzeugt wird. Dies wird durch die Maßnahmen des kennzeichnenden Teils erreicht.

Die Erfindung wird nun anhand der Figur der Zeichnung, die das Schaltbild eines Ausführungsbeispiels darstellt, weiter erläutert. Zur Lösung der Aufgabe ist der dritte Kondensator C3 vorgesehen, der wie die beiden anderen Kondensatoren C1, C2 einseitig am Schaltungsnullpunkt liegt. Der nullpunktabgewandte Anschluß des dritten Kondensators C3 liegt über den gesteuerten Strompfad des zweiten Entladetransistors T8 am Schaltungsnullpunkt, ferner am Eingang des aus den Transistoren T9, T10 bestehenden zweiten Sourcefolgers und über die Serienschaltung aus den gesteuerten Strompfaden des Verarmungs-typ-Transistors T7 mit direkter Gate-Source-Verbindung und des zweiten Ladetransistors T6 an der Betriebsspannung $-U_B$. Der Ausgang des zweiten Sourcefolgers liegt am Gate des dritten Entladetransistors T11, dessen gesteuerter Strompfad dem zweiten Kondensator C2 parallelgeschaltet ist. Das Gate des zweiten Ladetransistors T6 liegt an der ersten Taktspannung F1 und das des zweiten Entladetransistors T8 an der zweiten Taktspannung F2. Die Taktspannungen F1, F2 sind, wie bei Zweiphasen-MOS-Schaltungen üblich, Rechteckspannungen gleicher Frequenz, die um 180° gegeneinander phasenverschoben sind und sich nicht überlappen.

Der Verarmungstyp-Transistor T7 ist durch seine Gate-Source-Verbindung als Konstantstromquelle geschaltet, so daß, während die Taktspannung F1 abgeschaltet ist und somit das niedrigere Potential der Betriebsspannung $-U_B$ führt und dadurch der zweite Ladetransistor T6 leitend gesteuert ist, der dritte Kondensator C3 mit einem konstanten Strom aufgeladen wird. Dies führt über den zweiten Sourcefolger dazu, daß der dritte Entladetransistor T11 leitend gesteuert wird und somit den zweiten Kondensator C2 entlädt.

Werden die beiden Taktspannungen F1, F2 wieder eingeschaltet, so sperrt zunächst der zweite Ladetransistor T6, und der zweite Entladetransistor T8 wird leitend gesteuert, so daß der dritte Kondensator C3 kurzgeschlossen wird und daraufhin über den zweiten Sourcefolger der dritte Entladetransistor T11 ebenfalls gesperrt wird. Die Schaltung befindet sich dann also in einem Zustand, wie wenn die im Kennzeichen des Anspruchs angegebenen Merkmale nicht vorhanden wären. Die Schaltung arbeitet somit wie die bekannte Schaltung und gibt nach einigen Taktspannungswechseln das Normiersignal ab.

In realisierten Schaltungen hat sich ein Verhältnis der Kapazitätswerte des ersten und des zweiten Kondensators bewährt, das bei C2/C1 = 15 bis 20 liegt. Die Kapazität des Kondensators C3 liegt bei einigen Picofarad, z. B. 2 pF, und der vom Verarmungstyp-Transistor T7 gelieferte konstante Strom ist so gering gewählt, daß der zweite Kondensator C2 erst nach einer Zeit entladen wird, die etwa 20 bis 30 Pulsdauern der Taktspannungen F1, F2 entspricht. Somit ist bei eingeschalteten Taktspannungen die Aufladung des dritten Kondensators C3 für eine Durchschaltung des dritten Entladetransistors T11 nicht ausreichend.

## Patentanspruch

Schaltungsanordnung zur Ableitung eines Normiersignals bei Einschalten einer konstanten Betriebsspannung ($-U_B$) und der beiden Taktspannungen (F1, F2) von in Verhältnis-Technik mittels p-Kanal-Isolierschicht-Feldeffekttransistoren vom Anreicherungstyp integrierten Schaltungen
- mit einem einseitig am Schaltungsnullpunkt liegenden ersten Kondensator (C1), dessen anderer Anschluß über den gesteuerten Strompfad eines ersten Ladetransistors (T 1) an der Betriebsspannung ($-U_B$) liegt,
- mit einem einseitig am Schaltungsnullpunkt liegenden zweiten Kondensator (C2), dessen Kapazität wesentlich größer als die des ersten Kondensators (C1) ist und dessen anderer Anschluß über den gesteuerten Strompfad eines Umladetransistors (T2) in Serie zum Strompfad des ersten Ladetransistors (T1), ferner am Eingang eines ersten Sourcefolgers (T4, T5) und über einen ersten Entladetransistor (T3) mit direkter Source-Gate-Verbindung an der Betriebsspannung ($-U_B$) liegt,
- wobei das Gate des ersten Ladetransistors (T1) an der ersten Taktspannung (F1) und das Gate des Umladetransistors (T2) an der zweiten Taktspannung (F2) liegt,
gekennzeichnet durch folgende Merkmale:
- der andere Anschluß eines einseitig am Schaltungsnullpunkt liegenden dritten Kondensators (C3) liegt über die in Serie geschalteten, gesteuerten Strompfade eines Verarmungstyp-Transistors (T7) mit direkter Gate-Source-Verbindung und eines zweiten Ladetransistors (T6) an der Betriebsspannung ($-U_B$), ferner am Eingang eines zweiten Sourcefolgers (T9, T10) und über den gesteuerten Strompfad eines zweiten Entladetransistors (T8) am Schaltungsnullpunkt,
- der Ausgang des zweiten Sourcefolgers (T9, T10) ist mit dem Gate eines mit seinem gesteuerten Strompfad parallel zum zweiten Kondensator (C2) liegenden dritten Entladetransistors (T11) verbunden, und
- das Gate des zweiten Ladetransistors (T6) liegt an der ersten Taktspannung (F1) und das Gate des zweiten Entladetransistors (T8) an der zweiten Taktspannung (F2).

## Claim

A circuit for deriving a reset signal upon switching on a constant source of supply voltage ($-U_B$) and the two clock signals (F1, F2) of integrated circuits integrated by p-channel insulated-gate field-effect transistors of the enhancement type in accordance with the ratiotechnique,
- comprising a first capacitor (C1) applied with one side to the zero point of the circuit, with the other terminal thereof being applied via the controlled current path of a first charging transistor (T1), to the supply voltage ($-U_B$),
- comprising a second capacitor (C2) applied with one side to the zero points of the circuit, whose capacitance is substantially higher than that of said first capacitor (C1), with the other terminal thereof, via the controlled current path of a recharging transistor (T2), being applied in series with the current path of said first charging transistor (T1), and further being connected to the input of a first source follower (T4, T5) and, via a first discharge transistor (T3) having its source directly connected to its gate, to the supply voltage ($-U_B$),
- with the gate of said first charging transistor (T1) being applied to the first clock signal (F1), and the gate of the recharging transistor (T2) being applied to the second clock signal (F2),
characterized by the following features:
- the other terminal of a third capacitor (C3) which is applied with one terminal to the zero point of the circuit, is applied via the series-arranged, controlled current paths of a depletion-type transistor (T7) having its gate directly connected to its source and a second charging transistor (T6) to the supply voltage ($-U_B$), moreover to the input of a second source follower (T9, T10) and, via the controlled current path of a second discharge transistor (T8), to the zero point of the circuit,
- the output of the second source follower (T9, T10) is connected to the gate of a third discharge transistor (T11) which, with its controlled current path, is arranged in parallel with said second capacitor (C2), and
- the gate of the second charging transistor (T6) is applied to the first clock signal (F1) and the gate of the second discharge transistor (T8) is applied to the second clock signal (F2).

## Revendication

Circuit pour l'obtention d'un signal de remise à l'état initial lors de la connexion d'une source d'alimentation en tension constante ($-U_B$) et de deux signaux d'horloge (F1, F2) à des entrées respectives de circuits intégrés réalisés selon la technique des transistors à effet de champ à grille isolée et à canal p, de type à einrichisse-ment,

— comprenant un premier condensateur (C1) connecté d'un côté au point zéro du circuit et, de l'autre, par l'intermédiaire du circuit drain-source d'un premier transistor de charge (T1), à la tension d'alimentation ($-U_B$);

— et comprenant un deuxième condensateur (C2) dont la capacité est sensiblement plus importante que celle du premier condensateur (C1), connecté d'un côté au point zéro du circuit et, de l'autre côté, à travers le circuit drain-source d'un transistor de recharge (T2), connecté en série avec le circuit drain-source du premier transistor de charge (T1), et connecté en outre à l'entrée d'un premier montage à source suiveuse (T4, T5) et aussi, à travers un premier transistor de décharge (T3) ayant sa source directement commutée à sa grille, à la tension d'alimentation ($-U_B$);

— la grille dudit premier transistor de charge (T1) étant reliée au premier signal d'horloge (F1) et la grille du transistor de recharge (T2) étant reliée au deuxième signal d'horloge (F2);

ledit circuit étant caractérisé par le fait que

— la deuxième borne d'un troisième condensateur (C3), connecté par sa première borne au point zéro du circuit, est connectée à la tension d'alimentation ($-U_B$) à travers les circuits drain-source en série d'un transistor du type à appauvrissement (T7), dont la grille est directement connectée à la source, et d'un deuxième transistor de charge (T6), ainsi qu'à l'entrée d'un deuxième montage à source suiveuse (T9—T10) et, à travers le circuit drain-source d'un deuxième transistor de décharge (T8), au point zéro du circuit, par le fait que

— la sortie du deuxième montage à source suiveuse (T9, T10) est commutée à la grille d'un troisième transistor de décharge (T11) qui, par son circuit drainsource, est monté en parallèle sur ledit deuxième condensateur (C2);

— et par le fait que la grille du troisième transistor de charge (T6) est reliée au premier signal d'horloge (F1), et la grille du deuxième transistor de décharge (T8) au deuxième signal d'horloge (F2).